# EUROPÄISCHE PATENTSCHRIFT

(11) **EP 3 683 820 B1**
(45) Veröffentlichungstag und Bekanntmachung des Hinweises auf die Patenterteilung: **09.03.2022**
(21) Anmeldenummer: 19152528.6
(22) Anmeldetag: 18.01.2019
(51) Int. Cl.: H01J 27/02, H01J 37/317, H01J 37/305, H01J 37/08, F03H 1/00

(54) **VORRICHTUNG ZUR ERZEUGUNG VON IONENSTRAHLEN MIT ANPASSBAREN IONENSTRAHLPROFILEN**
DEVICE FOR GENERATING ION BEAMS WITH ADAPTABLE ION BEAM PROFILES
DISPOSITIF DE GÉNÉRATION DES FAISCEAUX IONIQUES POURVUS DE PROFILS DE FAISCEAU IONIQUES AJUSTABLES

(43) Veröffentlichungstag der Anmeldung: 22.07.2020
(73) Patentinhaber: Justus-Liebig-Universität Gießen, 35390 Gießen (DE)
(72) Erfinder: Klar, Peter, 35392 Gießen (DE); Chatterjee, Sangam, 35037 Marburg (DE); Holste, Kristof, 35390 Gießen (DE); Becker, Martin, 35625 Hüttenberg (DE)
(74) Vertreter: Stumpf, Peter

(56) Entgegenhaltungen:
- JP-A- S63 246 478
- JP-A- 2005 036 717
- US-A1- 2012 080 308
- US-B1- 8 703 001
- KAUFMAN H R: "TECHNOLOGY OF ION BEAM SOURCES USED IN SPUTTERING", JOURNAL OF VACUUM SCIENCE AND TECHNOLOGY, NEW YORK, NY, US, Bd. 15, Nr. 2, 1. März 1978 (1978-03-01), Seiten 272-276, XP000941288, ISSN: 0022-5355, DOI: 10.1116/1.569569
- RAY M A ET AL: "A MULTIAPERTURE ION SOURCE WITH ADJUSTABLE OPTICS TO PROVIDE WELL-COLLIMATED, HIGH-CURRENT-DENSITY, LOW-TO MEDIUM-ENERGY ION BEAMS", JOURNAL OF VACUUM SCIENCE AND TECHNOLOGY: PART A, AVS /AIP, MELVILLE, NY., US, Bd. 7, Nr. 2, 1. März 1989 (1989-03-01), Seiten 125-131, XP000008731, ISSN: 0734-2101, DOI: 10.1116/1.575740

## Beschreibung

Die vorliegende Erfindung betrifft eine Vorrichtung zur Erzeugung von Ionenstrahlen mit anpassbaren lonenstrahlprofilen beispielsweise zur Materialbearbeitung/-deposition oder zur Schuberzeugung im Weltraum.

### Beschreibung und Einleitung des allgemeinen Gebietes der Erfindung

lonenquellen oder auch Ionentriebwerke stellen einen gerichteten lonenstrahl zur Verfügung. Im Falle der lonenquellen für die Materialbearbeitung wird dieser Ionenstrahl genutzt, um ein Material zu bearbeiten, indem es dem lonenstrahl ausgesetzt wird. Im Falle der Ionentriebwerke wird der aufgrund der Impulserhaltung auftretende Rückstoß bei Ausstoß des lonenstrahls genutzt, um ein Raumfahrzeug, auf dem sich das Ionentriebwerk befindet, anzutreiben.

Im Allgemeinen sind die Strahlprofile von lonenquellen oder lonentriebwerken nur in geringen Grenzen variabel, d.h. insbesondere ist die grundsätzliche Form des räumlichen Profils (z.B. Gauß-Profil) durch die Konstruktionselemente der Quelle oder des Triebwerks vorgegeben. Änderungen der Betriebsparameter der Ionenquelle im spezifizierten Bereich führen i. A. nur zu einer Änderung der lonenenergie oder der Strahlintensität, wobei sich die grundsätzliche Form des räumlichen Profils abgesehen von einer Strahlaufweitung oder -verschmälerung nicht ändert. Häufig werden Ionenquellen oder Ionentriebwerke eingesetzt, bei denen die Ionen aus einem Plasma mit Hilfe eines Extraktionsgittersystems extrahiert werden. Dieses Extraktionsgittersystem wirkt als Ionenoptik und wird genutzt, um das Strahlprofil des extrahierten lonenstrahls zu definieren. Das in der lonenquelle starr verbaute Extraktionsgittersystem legt bei Gitter-lonenquellen und Gitter-lonentriebwerken das räumliche Profil des extrahierten lonenstrahls für eine Anwendung fest. Ist das räumliche Profil so festgelegt, dann ist es durch die Betriebsparameter kaum veränderbar. Darüber hinaus muss der Bereich der Betriebsparameter des Extraktionsgittersystems so gewählt werden, dass dieses bei der Extraktion der Ionen nicht durch Über- oder Unterfokussierung geschädigt wird, was die Variabilität im Strahlprofil, in der extrahierten Intensität des lonenstrahls und in der Energieverteilung der Ionen im Strahl zusätzlich einschränkt. Außerdem können sich die optimalen Betriebsbedingungen stark ändern, wenn das Gas oder die Gasmischung, das oder die als Betriebsmittel zur Plasmaerzeugung in der lonenquelle eingesetzt wird, gewechselt wird. Eine größere Variabilität in den drei wichtigen Strahl-Kenngrößen (räumliches Profil, mittlere Ionenenergie, Intensität) und im einsetzbaren Betriebsmittel ist für eine Vielzahl von Anwendungen sowohl in der Materialbearbeitung/- deposition als auch im Bereich der Schuberzeugung im Weltraum wünschenswert.

Beim Beschuss einer Oberfläche mit Ionen können, abhängig von den verwendeten Ionen und ihrer kinetischen Energie, verschiedene Effekte auftreten:
- Die Ionen kondensieren auf dem beschossenen Substrat und bilden dort eine Schicht. Dies wird als lonenstrahldeposition bezeichnet. Dies geschieht vorwiegend bei kleinen Energien.
- Material vom beschossenen Target wird als Sekundäremissionskeule (Sekundärplume) abgetragen. Dies wird als Sputtern bezeichnet. Dies geschieht vorwiegend bei mittleren Energien.
- Die Ionen werden in das Targetmaterial eingebaut und gehen dort gegebenenfalls eine chemische Verbindung ein. Dieser Effekt wird (reaktive) Ionenimplantation genannt. Dies geschieht vorwiegend bei hohen Energien.

Ist ein Materialabtrag beabsichtigt, so müssen die Ionen dafür eine gewisse Mindestenergie besitzen. Das auftreffende Ion überträgt seinen Impuls auf Atome des Targets, des beschossenen Materials, die dann in einer Stoßkaskade weitere Kollisionen auslösen. Nach mehreren Kollisionen hat ein Teil der Targetatome einen Impuls, der vom Targetinneren fortweist. Befindet sich ein solches Atom in der Nähe der Oberfläche und hat es eine hinreichend hohe Energie, dann kann es das Target verlassen.

Ionenstrahl-Sputterdeposition und lonenstrahlverdichten sind als Methoden der Dünnschichttechnologie prinzipiell aus der Literatur bekannt. In lonenstrahl-Sputter-Systemen werden die einfallenden Ionen in einer lonenquelle erzeugt, während sich das Target in einem lokal von der lonenquelle getrennten Bereich der Prozesskammer befindet. Zur lonenstrahl-Sputterdeposition bringt man in die Nähe des Targets zusätzlich ein Substrat, sodass die herausgeschlagenen Target-Atome auf diesem kondensieren und eine Schicht bilden können. Der Gasdruck in der Prozesskammer muss in diesem Prozess gering sein (Vakuum), damit die Targetatome das Substrat erreichen, ohne mit anderen Gasteilchen zusammenzustoßen. Das heißt, die mittlere freie Weglänge der Gasteilchen muss mindestens dem Abstand des Targets zum Substrat entsprechen. Bei einem Abstand von ca. 30 cm sollte der Gasdruck daher nicht größer als ca. 2×10⁻⁴ mbar (Hochvakuum) sein, andernfalls sind schlechtere Schichteigenschaften die Folge. Da die Substrate nicht der Entladung oder dem Strahl direkt ausgesetzt sind, werden sie nicht stark erwärmt. Daher kann nahezu jedes Material, das gesputtert werden kann, auf temperaturempfindlichen Substraten abgeschieden werden.

Schuberzeugung bei Raumfahrzeugen mit Hilfe von lonentriebwerken ist aus der Literatur bekannt. Ionentriebwerke sind aufgrund der hohen Austrittsgeschwindigkeiten der Ionen von bis zu 30 km/s masseneffizient zu betreiben, daher ist ihr Einsatz im Weltraum vorteilhaft. Schübe im Bereich von Mikro-Newton bis Newton sind realisierbar mit lonentriebwerken unterschiedlicher Größe. Dies erlaubt es, Ionentriebwerke in unterschiedlichen Missionsszenarien einzusetzen. Dazu gehören der Einsatz zur Bahnregelung bei kleinen Schüben ebenso wie der Einsatz als Marschtriebwerk beim Aufspiralen von Satelliten in ihren Zielorbit oder bei wissenschaftlichen Missionen wie z.B. zum Mars. Bei den häufig genutzten Gitter-Ionentriebwerken bestimmen die am Extraktionsgittersystem angelegten Spannungen und die Anordnung und Größe der Extraktionsöffnungen der einzelnen Extraktionsgitter des Systems zusammen mit den Plasmaparametern im Inneren des Triebwerks die Funktion der Ionenoptik. Die optimale Einstellung der Ionenoptik variiert mit dem zu erzeugenden Schub sowie mit dem im Plasma eingesetzten Betriebsmittel (Treibstoff).

### Stand der Technik

Ionenquellen für die Materialbearbeitung und Ionentriebwerke für die Schuberzeugung sind baulich bedingt in der Variabilität des räumlichen Profils, der Energieverteilung und der extrahierten Intensität eingeschränkt. Außerdem unterscheiden sich die optimalen Betriebsparameter für verschiedene Betriebsmittel stark. Für viele Anwendungen ist eine möglichst große Variabilität der drei Strahl-Kenngrößen und des Betriebsmittels vorteilhaft.

Mit gängigen Beschichtungssystemen ist es heute nicht möglich, routinemäßig in Produktionslinien nichtplane Oberflächen, d. h. Freiformen und insbesondere auch Freiform-Optiken, konform mit Multischichten zu versehen. In der Praxis wird derzeit auf hochkomplexe und damit mechanisch sehr anfällige Planetengetriebe im Vakuum zurückgegriffen, um einzelne Freiformen zu beschichten. D. h., Konformität wird dadurch erzielt, dass das zu beschichtende Objekt während des Beschichtungsprozesses bewegt werden muss.

Im Falle der Materialdeposition sind konventionelle Techniken der Dünnschichtbearbeitung zumeist für planare Substrate optimiert. Die Methode der Atomlagendeposition (ALD) stellt hierbei eine Ausnahme dar und erlaubt prinzipiell die selbstterminierte Beschichtung beliebig geformter Oberflächen. ALD-Beschichtungen werden jedoch Atomlage für Atomlage aufgebaut und unterliegen daher vergleichsweise geringen Depositionsraten. Ein wirtschaftlicher Einsatz ist daher stark limitiert. Im Rahmen der Verwendung von Ionenquellen basieren wirtschaftlich denkbare Prozesse bisher auf der Verwendung mehrerer Ionenquellen. US8703001 offenbart ein lonenstrahlbearbeitungssystem mit zueinander beweglichen Extraktionsgittern.

Bei den Gitter-lonentriebwerken in der Raumfahrt sind Triebwerke, auch wenn sie in verschiedenen Betriebsmodi während der Mission betrieben werden, immer nur mit einem fest verbauten Extraktionsgittersystem ausgestattet. Die resultierende lonenoptik stellt einen Kompromiss dar, da sie nicht gleichzeitig für verschiedene Betriebsmodi des Triebwerks optimiert sein kann. JP2005036717 offenbart ein Ionentriebwerk mit zwei zueinander beweglichen Extraktionsgittern.

Mit gängigen Beschichtungssystemen ist eine konforme Beschichtung mit Multischichten nahezu nicht umsetzbar. Ein Einsatz mehrerer Ionenquellen mit jeweils eigener, aber generell abzustimmender Steuerelektronik, ist denkbar, aber mit hohen Kosten verbunden.

Bei Gitter-lonentriebwerken, die während der Mission in verschiedenen Betriebsmodi mit dem gleichen Extraktionsgittersystem arbeiten, ist die Performance nicht optimal und der Verschleiß größer als im Falle von wechselbaren auf den jeweiligen Betriebsmodus zugeschnittenen Extraktionsgittersystemen. Da keine Wartungsarbeiten im Weltraum möglich bzw. vorgesehen sind, kann der Verschleiß des Extraktionsgittersystems in Triebwerksausfällen resultieren, die dann zu einem unplanmäßigen Ausfall des Satellitensystems führen können, weil z.B. keine Bahnregelung mehr möglich ist.

Von Gitter-lonenquellen, die als lonenquellen für die Materialbearbeitung oder auch als Ionentriebwerke eingesetzt werden können, gibt es zwei Arten. So gibt es zum einen Gitter-lonenquellen, welche auf die Ausbildung hoch fokussierter Ionenstrahlen optimiert sind und damit z.B. zwecks Behandlung großflächiger Substrate bewegt werden müssen. Hoch fokussiert bedeutet, dass der Fokusdurchmesser kleiner als 1 cm² ist. Weiterhin gibt es Breitstrahlionenquellen. Letztere werden zur großflächigen Modifikation von Materialien (Sputtern, Ätzen etc.) eingesetzt. Großflächig bedeutet, dass Flächen von wenigstens 100 cm² bestrahlt werden können. Ebenso können Breitstrahlionenquellen als Ionentriebwerke eingesetzt werden.

### Aufgabe

Aufgabe der vorliegenden Erfindung ist es, eine Vorrichtung zur Erzeugung von Ionenstrahlen mit anpassbaren lonenstrahlprofilen bereitzustellen, welche beispielsweise die Beschichtung von Objekten von beliebiger Geometrie mit einem bestimmten Schichtdickenprofil oder den Betrieb von Gitter-Ionentriebwerken in verschiedenen Betriebsmodi mit einem einstellbaren Extraktionsgittersystem ermöglicht, was sowohl die Lebensdauer der Triebwerke erhöht als auch flexiblere Einsatzmöglichkeiten bietet.

### Lösung der Aufgabe

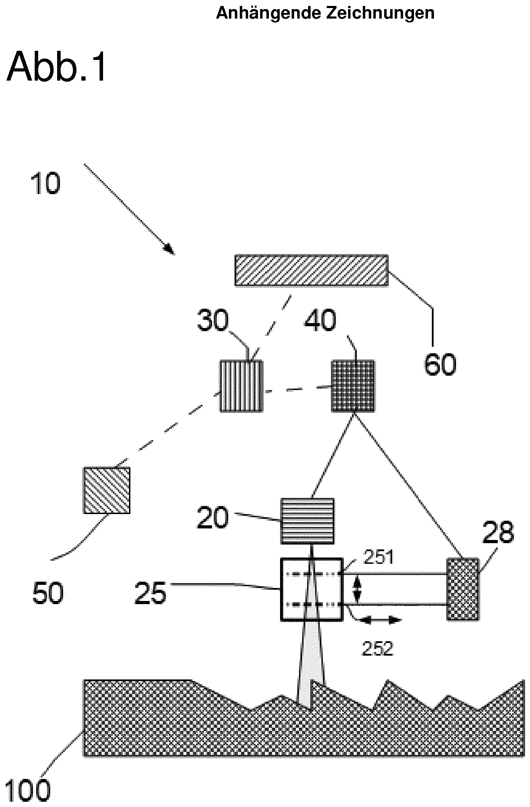

Die Aufgabe wird durch die Vorrichtung mit den Merkmalen des Hauptanspruchs gelöst (Abb. 1). Vorteilhafte Weiterbildungen der Erfindung sind in den Unteransprüchen beschrieben.

Die erfindungsgemäße Vorrichtung 10 zur Erzeugung von lonenstrahlen mit anpassbaren lonenstrahlprofilen umfasst dabei wenigstens eine lonenquelle mit einem Plasmagefäß 20 und mit wenigstens einer Ionenoptik 25. Mechanisches Hauptbauelement der lonenoptik 25 ist das Extraktionsgittersystem. Das Extraktionsgittersystem besteht dabei aus wenigstens zwei Extraktionsgittern 251, 252, die voneinander elektrisch getrennt sind. Typische Abstände zwischen den Extraktionsgittern eines Extraktionsgittersystems liegen im Millimeterbereich. Extraktionsgitter sind dabei großflächige gitterförmige Elektroden mit typischen Dicken im Bereich von 100 µm bis 1 cm und lateralen Abmessungen im Bereich von 1 cm bis 1 m, die plan oder gewölbt sein können. Die Extraktionsöffnungen der Extraktionsgitter haben typische Abmessungen im Bereich von 100 µm bis mehrere 10 cm und können in der Form beliebig ausgebildet sein, z. B. kreisförmig, ellipsenförmig oder schlitz- oder streifenartig. Jedes der Extraktionsgitter umfasst mehrere Teilgitter,

die in elektrischem Kontakt stehen und gegeneinander beweglich sind. Extraktionsgitter und Teilgitter bestehen aus elektrisch leitenden Materialien, z. B. Metallen wie Titan oder Molybdän oder auch Nichtmetallen wie Kohlenstoff oder Kohlenstoffverbundmaterialien.

Die Positionen der Teilgitter zueinander bestimmen die Anzahl, Anordnung und Form der wirksamen Extraktionsöffnungen der einzelnen Extraktionsgitter. Der Überlapp der Extraktionsöffnungen der unterschiedlichen Extraktionsgitter in der Projektionsebene senkrecht zur nominellen Strahlachse legt wiederum die Größe und Form der einzelnen Extraktionskanäle des Extraktionsgittersystems fest. Die voneinander elektrisch getrennten Extraktionsgitter werden durch eine externe Spannungsversorgung auf die benötigten elektrischen Potentiale gelegt. Dies geschieht, um die gewünschten Strahl-Kenngrößen des extrahierten lonenstrahls gezielt einzustellen.

Weiterhin umfasst die Vorrichtung eine Gittersteuerung 28. Diese ist so ausgebildet, dass sie die Positionen der Extraktionsgitter 251 und 251 als Ganzes zueinander verändern kann, sodass lonenstrahlen mit verschiedenen lonenstrahlprofilen erzeugt werden können.

Dabei ist die Gittersteuerung 28 so ausgebildet ist, dass sie auch die Teilgitter der der wenigstens zwei Extraktionsgitter 251, 252 bewegen kann, sodass zusätzlich die Positionen der Teilgitter zueinander veränderbar sind und dadurch das Ionenstrahlprofil veränderbar ist. Die Gittersteuerung 28 kann dann entweder nur die Extraktionsgitter bewegen; nur Teilgitter bewegen oder sowohl Extraktionsgitter als auch Teilgitter bewegen.

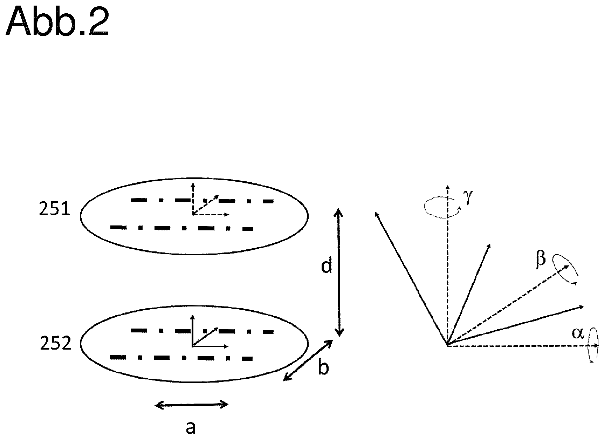

Die Position der Extraktionsgitter 251 und 252 zueinander ist durch mehrere Variablen bestimmt, welche über Positionsparameter beschrieben werden können. Dies wird in Abb. 2 verdeutlicht.

Die Positionsparameter sind dabei:
a,b: laterale Verschiebung der Extraktionsgitter 251 und 252 zueinander, wenn die Extraktionsgitter parallel zueinander angeordnet sind.
d: mittlere Abstand der Extraktionsgitter 251 und 252 zueinander α und β: Verkippungswinkel der Gitterebenen der Extraktionsgitter 251 und 252 zueinander
y: Drehwinkel der Gitterebenen der Extraktionsgitter 251 und 252 zueinander, wenn die Gitter parallel zueinander angeordnet sind.

Die Gittersteuerung ist so ausgebildet, dass sie die Positionsparameter a und b über einem Bereich von 1 cm bis 20 cm und den Positionsparameter d über einen Bereich von 1 mm bis 20 mm mit einer maximalen Positionsungenauigkeit von unter 10 µm einstellen kann. Dies kann beispielsweise über lineare mechanische Verstelleinheiten oder piezoelektrische Verstelleinheiten oder Kombinationen dieser erfolgen. Weiterhin ist die Gittersteuerung so ausgebildet, dass sie die Verkippungswinkel α und β in einem Bereich 1° bis 45° und den Drehwinkel γ über den vollen Winkelbereich (0° bis 180°) kontinuierlich mit einer maximalen Winkelungenauigkeit von unter 1° einstellen kann. Die γ-Rotation kann z. B. durch eine Welle, die über einen äußeren Zahnkranz am Gitter dieses bewegt, realisiert werden. Auf ähnliche Weise oder auch über Piezoversteller lassen sich auch α- und β-Rotationen realisieren. Prinzipiell lassen sich die Bewegungsfreiheitsgrade alle kombinieren, so dass die Extraktionsgitter im vorgegebenen Bereich frei orientierbar sind. Die hier angegebenen Werte geben beispielhafte aber für viele Anwendungen übliche Anforderungen wieder. Größere Einstellbereiche und/oder kleine maximale Ungenauigkeiten in der Parametereinstellung können aber für bestimmte spezielle Anwendungen vorteilhaft oder sogar notwendig sein.

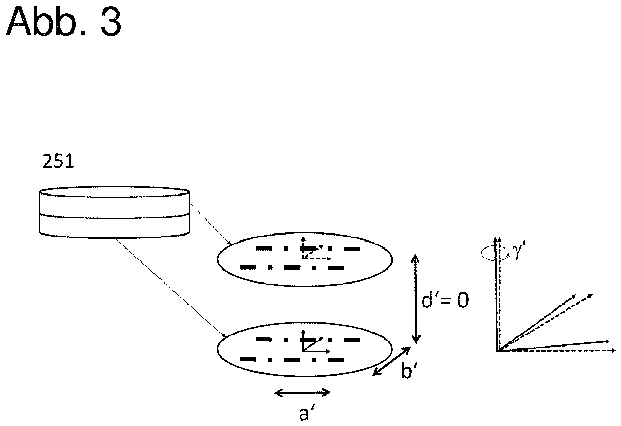

Hinzu kommen für Extraktionsgitter, die aus mehreren, in elektrischem Kontakt stehenden Teilgittern aufgebaut sind, weitere Variablen, die die Positionen der zusammengefügten Teilgitter bestimmen. Diese Positionsparameter sind in Abb. 3 noch einmal verdeutlicht.

Die Positionsparameter zwischen je zwei Teilgittern eines Extraktionsgitters sind dabei:
a',b': laterale Verschiebung der Teilgitter zueinander, wenn die Teilgitter parallel zueinander angeordnet sind.
d': mittlere Abstand der Teilgitter zueinander, i. A. d' = 0
γ': Drehwinkel der Gitterebenen der Teilgitter zueinander, wenn die Teilgitter parallel zueinander angeordnet sind.

Die Gittersteuerung ist so ausgebildet, dass sie die a' und b' über einem Bereich von 1 cm bis 20 cm und den Positionsparameter d' über einen Bereich von 1 mm bis 20 mm mit einer maximalen Positionsungenauigkeit von unter 10 µm einstellen kann. Es ist sichergestellt, dass die Teilgitter bei Betrieb der Quelle in elektrischem Kontakt stehen. Dies kann beispielsweise durch Schleifkontakte oder durch flexible elektrische Verbindungen erfolgen. Beim Verstellen der Teilgitter kann es von Vorteil sein, die elektrischen Kontaktierung während des Verfahrens der Teilgitter gegeneinander zu unterrechen. Dies ist bei Schleifkontakten oder Kontaktierung durch Anpressdruck realisierbar. Weiterhin ist die Gittersteuerung so ausgebildet, dass sie den Drehwinkel γ' über den vollen Winkelbereich (0° bis 180°) kontinuierlich mit einer maximalen Winkelungenauigkeit von unter 1° einstellen kann. Die γ' Rotation lässt sich in ähnlicher Weise wie die γ-Rotation realisieren.

Diese Aufzählung ist dabei nicht abschließend zu verstehen. Insbesondere die Änderungsraten der genannten Positionsparameter stellen ihrerseits weitere Variablen dar.

Die Gittersteuerung 28 ist dabei so ausgebildet, dass sie jede dieser Variablen der Position separat oder mehrere Variablen in Kombination verändern kann. Dabei ist die Gittersteuerung so angeordnet, dass sie jedes Extraktionsgitter 251, 252 und auch dessen Teilgitter separat oder mehrere Extraktionsgitter und/oder deren Teilgitter in Kombination bewegen kann. Die Bewegung kann dabei schrittweise oder kontinuierlich erfolgen. Eine kontinuierliche Änderung ist hierbei besonders vorteilhaft. Die dazu notwendige Positionsüberwachung kann beispielsweise durch optische Methoden als auch durch GMR (giant magnetoresistance) - Sensorik sichergestellt werden.

Weiterhin erlaubt die Gittersteuerung eine zeitliche Veränderung der Positionsparameter. Damit kann das Strahlprofil der Gitter-lonenquelle oder des Gitter-Ionentriebwerks gezielt im Betrieb verändert werden. Z. B. kann so das Strahlprofil während einer Beschichtung mittels Sputter-Deposition angepasst werden, um die Beschichtung zu optimieren. Beim Betrieb eines Gitter-lonentriebwerks kann so z. B. zwischen zwei Betriebsmodi kontinuierlich umgestellt werden oder es können Gitterdegradationseffekte kompensiert werden.

Die Ansteuerung der Gittersteuerung kann beispielsweise über ein Steuerungsmittel erfolgen.

Wenn die Ionenoptik 25 zwei oder mehrere durch die Gittersteuerung 28 gegeneinander verschiebbare oder rotierbare in Strahlrichtung hintereinander angeordneten Extraktionsgitter mit gleichen oder auch verschiedenen Anordnungen von Extraktionsöffnungen umfasst, entstehen in diesem Verbund nur Extraktionskanäle, wenn die Projektionen der Extraktionsöffnungen aller Teilgitter der Extraktionsgitter in der Projektionsebene senkrecht zur nominellen Strahlrichtung überlappen. Bei gleichen Extraktionsöffnungsanordnungen in allen Extraktionsgittern kann man beispielsweise durch Rotieren eines der Teilgitter die Form der Extraktionsöffnungen des zugehörigen Extraktionsgitters verändern und damit die durch beide Extraktionsgitter entstehenden Extraktionskanäle beeinflussen. Im Falle unterschiedlicher Extraktionsöffnungsanzahlen in den Teilgittern der Extraktionsgitter oder in den Extraktionsöffnungsanordnungen der Extraktionsgitter selbst, kann durch eine Verschiebung oder Rotation der Teilgitter oder der Extraktionsgitter als Ganzes gegeneinander auch die Zahl und Anordnung der Extraktionskanäle verändert werden. Dies kann z.B. zu Moiré-artigen Effekten im Strahlprofil führen, die sich auf die Oberfläche des bearbeitenden Objektes 100 übertragen ließen.

In einer bevorzugten Ausbildung der erfindungsgemäßen Vorrichtung stellen die Kombinationen aus dem Plasmagefäß 20 mit der verstellbaren Ionenoptik 25 jeweils eine Gitterionenquelle dar.

Das Plasmagefäß 20 der lonenquelle weist einen Gaseinlass auf. Durch diesen Gaseinlass kann das notwendige Betriebsmittel eingeleitet werden.

Für die Materialbearbeitung nutzt man im Allgemeinen inerte Gase und/oder Gasgemische aus inertem Prozessgas und Reaktivgas als Betriebsmittel (auch als Prozessgas bezeichnet) in der lonenquelle. Als Inertgas wird häufig Argon eingesetzt, aber auch der Einsatz anderer Edelgase ist möglich. Bei Gasgemischen wird oft, aber nicht notwendig, ein reaktives Gas wie Sauerstoff oder Stickstoff zugesetzt, so ist es beispielweise möglich, ausgehend von metallischen Targets oxydische oder nitridische Beschichtungen herzustellen.

In lonentriebwerken wird als Betriebsmittel (auch als Treibstoff bezeichnet) aktuell üblicherweise das Inertgas Xenon eingesetzt. Alternativen zu Xenon gibt es sowohl im Bereich der atomaren Treibstoffe wie z. B. Krypton als auch im Bereich der molekularen Treibstoffe wie z. B. Jod, Sauerstoff, Stickstoff. Auch komplexere Moleküle wie Diamantoide werden gemäß aktueller Forschung eingesetzt.

Weiterhin besteht das Plasmagefäß 20 der lonenquelle aus elektrisch isolierendem Material (z. B. Glas, Kunststoff), in welches das Betriebsmittel eingeleitet werden kann. Es ist dabei so ausgebildet, dass die lonisationsprozesse beispielsweise durch Einkoppeln eines hochfrequenten Wechselfeldes im Inneren des Gefäßes initiiert werden können, um das Betriebsmittel zu ionisieren. Es besitzt weiterhin eine offene Seite, über welche der erzeugte lonenstrahl das Plasmagefäß 20 verlassen kann. Im Betrieb wird diese offene Seite durch die Ionenoptik 25 abgeschlossen. Die Ionenoptik 25 umfasst ein Extraktionsgittersystem, welches wenigstens zwei voneinander elektrisch getrennte Extraktionsgitter 251, 252 umfasst, die wiederum aus elektrisch in Kontakt stehenden Teilgittern aufgebaut sein können. Die Gittersteuerung 28 dient zur Bewegung der wenigstens zwei Extraktionsgitter 251 und 252 und/oder derer Teilgitter, sodass sowohl die Position der Extraktionsgitter 251, 252 zueinander als auch die der Teilgitter innerhalb eines Extraktionsgitters zueinander unabhängig einstellbar sind, wodurch sich das lonenstrahlprofil gezielt und kontinuierlich einstellen lässt. Das Extraktionsgittersystem ist so ausgebildet, dass die aus den lonisationsprozessen resultierenden Ionen durch thermische Diffusion aus dem Plasma in die Extraktionskanäle eintreten, durch das elektrische Feld zwischen den Extraktionsgittern entlang der Extraktionskanäle beschleunigt werden und dabei Energie aufnehmen. Diese so aus den Extraktionskanälen der Gitter-Ionenquelle freigesetzten Ionen überlagern sich zum aus der Gitter-lonenquelle austretenden lonenstrahl. Typische mittlere lonenenergien des lonenstrahls liegen im Bereich von 10 eV bis zu 10 keV.

Bei einem 2-Gittersystem oder 3-Gittersystem können durch die Gittersteuerung die Abstände zwischen den hintereinander angeordneten Extraktionsgittern (Plasmaanker, Beschleunigungs- und Bremsgitter) des Extraktionsgittersystems variiert werden. Beispielsweise entsteht in einem 3-Gittersystem die Wirkung einer "Zoom"-Linse (d.h. der Fokuspunkt des lonenstrahls kann kontinuierlich und gezielt entlang der lonenstrahlachse verschoben werden), wenn das Beschleunigungsgitter (mittlere Extraktionsgitter) gegenüber den beiden äußeren Extraktionsgittern bei konstanten Beschleunigungsspannungen zwischen den Gittern verfahren wird.

In einer zweiten generellen Ausführungsform der Erfindung umfasst die erfindungsgemäße Vorrichtung 10 ein Steuerungsmittel 40 zusätzlich zur Gittersteuerung 28, die zur Einstellung des Strahlprofiles der lonenquelle aus Plasmagefäß 20 und lonenoptik 25 durch Einstellung des Extraktionsgitter 251, 252 genutzt wird. Durch das Steuerungsmittel 40 wird eine zusätzliche Möglichkeit zur Einstellung des Strahlprofiles der lonenquelle bereitgestellt.

Zum Steuerungsmittel 40 können beispielsweise zusätzlich gehören: Blenden z. B. zum teilweisen oder vollständigen Abblenden des primären lonenstrahls oder des durch den lonenstrahl von einem Target erzeugten Sekundärstrahls in Beschichtungsprozessen, Magnete z. B. zur Formung von Primär- oder Sekundärionenstrahlen in Beschichtungsprozessen oder zur weiteren Modifikation des lonenstrahls beim Einsatz als Ionentriebwerk, Stellmotoren zum Bewegen einer oder mehrerer Ionenquellen im Falle der Materialbearbeitung oder des Triebwerkeinsatzes oder Stellmotoren zum Bewegen des zu beschichtenden Objektes im Falle der Materialbearbeitung. Die Verwendung weiterer Bauelemente ist möglich.

In einer dritten Ausführungsform umfasst die erfindungsmäße Vorrichtung 10 zusätzlich ein Auswertemittel 30. Dieses dient beispielsweise dazu, Daten über mögliche Strahlparameter und Strahlprofile der lonenquelle aus Plasmagefäß 20 und Ionenoptik 25 oder im Fall der Materialbearbeitung, Daten über das zu bearbeitende Objekt 100 zu empfangen und zu speichern. Weiterhin dient das Auswertemittel 30 dazu, diese Daten an einen externen Empfänger (z. B. eine Bodenstation im Falle eines Gitter-lonentriebwerks) zu senden oder aus diesen Daten im Falle der Materialbearbeitung, einen Bestrahlungsplan oder im Falle des Ionentriebwerks einen Betriebsplan zu erstellen und diesen an das Steuerungsmittel 40 zu senden.

Als Auswertemittel 30 dient dabei ein Gerät zur elektronischen Datenverarbeitung, z. B. ein in die Vorrichtung integrierter programmierbarer Mikroprozessor. Das Auswertemittel 30 ist weiterhin so ausgebildet, dass es die Ergebnisse eines Erfassungsmittels 50 und/oder eines Eingabemittels 60 auswerten und die Resultate an ein Steuerungsmittel 40 übermitteln kann.

Prozessdaten für den Beschichtungsprozess im Falle der Materialbearbeitung sind dabei in einer internen Datenbank des Auswertemittels 30 hinterlegt oder werden durch einen Datenaustausch mit einer externen Datenbank beispielsweise über ein Netzwerk oder eine Funkstrecke oder durch einen Datenaustausch mit einem Erfassungsmittel 50 bezogen. Dazu weist das Auswertemittel 30 vorzugsweise eine Schnittstelle zum elektronischen Datenaustausch (engl. electronic data interchange, EDI) auf.

Die Daten über mögliche Prozessparameter oder Betriebsmodi der lonenquelle oder des Ionentriebwerks bestehend aus Plasmagefäß 20 und lonenoptik 25, sind dabei in einer internen Datenbank des Auswertemittels 30 hinterlegt oder werden durch einen Datenaustausch mit einer externen Datenbank beispielsweise über ein Netzwerk oder eine Funkstrecke oder durch einen Datenaustausch mit einem Eingabemittel 60 bezogen.

In einer vierten Ausführungsform umfasst die erfindungsgemäße Vorrichtung 10 weiterhin noch ein Eingabemittel 60. Das Eingabemittel 60 dient dazu, die Daten über mögliche Strahlprofile der lonenquelle oder des Ionentriebwerks bestehend aus Plasmagefäß 20 und Ionenoptik 25 einzugeben und an das Auswertemittel 30 zur weiteren Verarbeitung zu übertragen. Zusätzlich können noch je nach Verwendung der erfindungsgemäßen Vorrichtung zur Erzeugung von lonenstrahlen, Daten über gewünschte Schichtdickenprofile oder Ätzprofile bei einer Nutzung in der Materialbearbeitung oder über verschiedene Betriebsmodi für den Betrieb als Ionentriebwerk mit dem Eingabemittel 60 eingegeben werden. Beim Eingabemittel 60 kann es sich um eine Tastatur oder um eine grafische Benutzeroberfläche oder auch grafische Benutzerschnittstelle (Abk. GUI von englisch graphical user interface) handeln.

In einer fünften Ausführungsform umfasst die erfindungsgemäße Vorrichtung 10 weiterhin noch ein Erfassungsmittel 50. Im Falle der Materialbearbeitung kann das Erfassungsmittel 50 beispielsweise eine Kamera sein und dazu dienen, die Oberfläche eines zu beschichtenden oder bearbeitenden Objektes 100 zu erfassen und die Oberflächendaten dann an das Auswertemittel 30 zur weiteren Verarbeitung zu übertragen. Im Falle eines Gitter-lonentriebwerks kann das Erfassungsmittel 50 beispielsweise die Ströme an den Extraktionsgittern im Betrieb erfassen und an das Auswertemittel 30 zur weiteren Verarbeitung übertragen. Der Einsatz des Erfassungsmittels 50 kann alternativ oder ergänzend zum Eingabemittel 60 erfolgen.

Vorteil gegenüber bisherigen Ansätzen mit einer lonenquelle mit statischem Extraktionssystem ist die höhere Flexibilität, die es erlaubt, alle Aufgaben, die eine Veränderung des Strahlprofils der lonenquelle über einen großen Bereich erfordern, flexibler und besser mit einer lonenquelle zu erfüllen, z. B. bei der Freiformbeschichtung. Durch die optimale Einstellung des Gitters für die jeweiligen Betriebsparameter wird die Gittererosion reduziert, was bei der Materialdeposition zu reineren Schichten führt und im lonentriebwerken auf Satelliten zu längeren Lebensdauern.

Vorteil gegenüber bisherigen Ansätzen mit mehreren Ionenquellen ist, dass die gleichen Aufgaben mit nur einer lonenquelle erfüllt werden können, sodass man auch nur eine Gas- und eine elektrische Versorgung vorhalten muss.

Im Falle der Materialdeposition ist es ein Vorteil, dass die Anordnung mit nur einer lonenquelle bzgl. Target auskommt. Dies ist einfacher, weniger fehleranfällig und platzsparender, als eine Anordnung mit mehreren Ionenquellen.

Neben den bisher beschriebenen Anwendungen in der Oberflächenbeschichtung kann die erfindungsgemäße Vorrichtung auch für gezielten Oberflächenabtrag (z.B. lonenstrahlätzen) Verwendung finden. Hier können die Strahlprofile kombiniert werden, um eine höchstgenaue, gezielte Strukturierung der bearbeiteten Oberfläche herbeizuführen.

Im Falle des Einsatzes von Gitter-lonenquellen als Ionentriebwerke auf Satelliten oder anderen Raumfahrzeugen sind für das gleiche Ionentriebwerk oft je nach Aufgabenstellung (orbit raising, station keeping, deep space mission) verschiedene Betriebsmodi vorgesehen, z.B. hoher Schub oder hoher spezifischer Impuls. Letzterer ist dabei eine Art Gütefaktor für die Treibstoffnutzung. Je höher der Wert des spezifischen Impulses ist, desto mehr Schub bekommt man pro Kilo Treibstoff oder umso länger kann die Extraktion des Triebwerkes aktiv sein. Aktuell wird beim Extraktionssystem ein Kompromiss zwischen Schub und spezifischem Impuls geschlossen. Eine Anpassung des Gittersystems durch Variation der Position der Extraktionsgitterposition zueinander je nach Betriebsmodus oder Neujustierung des beim Aufspiralvorgang (engl. orbit raising) durch Materialabtrag erodierten Gitters wäre von großem Vorteil. Die flexible Anpassung des Extraktionssystems könnte also - zusätzlich zur oben angeführten Verlängerung der Lebensdauer der Antriebssystems - die Effizienz des Triebwerks im jeweiligen Betriebsmodus durch das Nutzen einer optimal auf den Betriebsmodus zugeschnittenen Ionenoptik erhöhen.

### Abbildungslegende

Abb. 1 Schematische Darstellung der erfindungsgemäßen Vorrichtung 10 bestehend aus wenigstens Plasmagefäß 20 und Ionenoptik 25 zur Erzeugung von Ionenstrahlen mit anpassbaren lonenstrahlprofilen, wobei das gezeigte Auswertemittel 30, Steuerungsmittel 40, Erfassungsmittel 50 und das Eingabemittel 60 optional sind. Das mittels lonenstrahl zu bearbeitende Objekt 100 ist nur im Falle einer Anwendung in der Materialbearbeitung/-deposition relevant.
Abb. 2 Beispielhafte Darstellung der wesentlichen Positionsparameter zweier Extraktionsgitter
Abb. 3 Beispielhafte Darstellung der wesentlichen Positionsparameter zweier Teilgitter eines Extraktionsgitters

### Bezugszeichenliste

10 Vorrichtung zur Erzeugung von lonenstrahlen mit anpassbaren lonenstrahlProfilen
20 Plasmagefäß
25 Ionenoptik
251, 252 Extraktionsgitter
28 Gittersteuerung
30 Auswertemittel
40 Steuerungsmittel
50 Erfassungsmittel
60 Eingabemittel
100 zu bearbeitendes Objekt
a, b laterale Verschiebung der Extraktionsgitter
d mittlerer Abstand der Extraktionsgitter
α, β Verkippungswinkel der Gitterebenen der Extraktionsgitter
γ' Drehwinkel der Gitterebenen der Extraktionsgitter
a', b' laterale Verschiebung der Teilgitter
d' mittlerer Abstand der Teilgitter
γ' Drehwinkel der Gitterebenen der Teilgitter

## Patentansprüche

1. Vorrichtung (10) zur Erzeugung von lonenstrahlen mit definierten Ionenstrahlprofilen umfassend:
wenigstens eine lonenquelle mit einem Plasmagefäß (20) und mit einer Ionenoptik (25), wobei die Ionenoptik (25) wenigstens zwei voneinander elektrisch getrennte Extraktionsgitter (251, 252) zur Erzeugung eines lonenstrahls umfasst, wobei die Vorrichtung (10) eine Gittersteuerung (28) zur Bewegung der wenigstens zwei Extraktionsgitter (251, 252) aufweist, sodass die Positionen der Extraktionsgitter (251, 252) zueinander veränderbar sind und dadurch das lonenstrahlprofil veränderbar ist **dadurch gekennzeichnet, dass** jedes Extraktionsgitter (251,252) jeweils mehrere Teilgitter aufweist und die Gittersteuerung (28) so ausgebildet ist, dass sie auch die Teilgitter der wenigstens zwei Extraktionsgitter (251, 252) bewegen kann, sodass die Positionen der Teilgitter zueinander veränderbar sind und auch dadurch das lonenstrahlprofil veränderbar ist.

2. Vorrichtung (10) gemäß Anspruch 1 **dadurch gekennzeichnet, dass** diese weiterhin ein Steuerungsmittel (40) zur Veränderung des lonenstrahlprofiles umfasst.

3. Vorrichtung (10) gemäß Anspruch 1 oder 2 **dadurch gekennzeichnet, dass** diese weiterhin ein Auswertemittel (30) umfasst zum Empfang und Speicherung von Daten über mögliche Strahlprofile sowie zur Weiterleitung dieser Daten oder daraus abgeleiteter Daten an die Gittersteuerung (28) und das Steuerungsmittel (40) oder externe Empfänger.

4. Vorrichtung (10) gemäß Anspruch 3 **dadurch gekennzeichnet, dass** diese weiterhin ein Eingabemittel (60) zur Eingabe der Daten über mögliche Ionenstrahlprofile und zur Weiterleitung dieser Daten an das Auswertemittel (30) umfasst.

5. Vorrichtung (10) gemäß Anspruch 3 oder 4 **dadurch gekennzeichnet, dass** diese weiterhin ein Erfassungsmittel (50) umfasst zur Erfassung von Betriebsdaten der lonenquelle und zur Übertragung der Daten an das Auswertemittel (30) zur weiteren Verarbeitung.

6. Ionentriebwerk **dadurch gekennzeichnet, dass** es eine Vorrichtung (10) gemäß einem der vorigen Ansprüche aufweist.

7. Verwendung einer Vorrichtung gemäß einem der Ansprüche 1 bis 5 zur Materialbearbeitung einer Oberfläche eines zu bearbeitenden Objektes (100).

8. Verwendung einer Vorrichtung gemäß einem der Ansprüche 1 bis 5 zur Beschichtung einer Oberfläche eines zu bearbeitenden Objektes (100).

## Claims

1. Device (10) for generating ion beams with defined ion beam profiles comprising:
at least one ion source with a plasma vessel (20) and with an ion optics (25), the ion optics (25) comprising at least two extraction gratings (251, 252), electrically separated from one another, for generating an ion beam, the device (10) having a grating control (28) for moving the at least two extraction gratings (251, 252), so that the positions of the extraction gratings (251, 252) can be changed relative to one another and the ion beam profile can thereby be changed,
**characterized in that** each extraction grid (251, 252) has in each case a plurality of sub-grids and the grid control (28) is designed in such a way that it can also move the sub-grids of the at least two extraction grids (251, 252), so that the positions of the sub-grids relative to one another can be changed and the ion beam profile can also thereby be changed.

2. Device (10) according to claim 1, **characterized in that** it further comprises a control means (40) for changing the ion beam profile.

3. Device (10) according to claim 1 or 2, **characterised in that** it further comprises an evaluation means (30) for receiving and storing data on possible beam profiles and for forwarding this data or data derived therefrom to the grid control (28) and the control means (40) or external receivers.

4. Device (10) according to claim 3, **characterized in that** it further comprises input means (60) for inputting the data on possible ion beam profiles and for forwarding these data to the evaluation means (30).

5. Device (10) according to claim 3 or 4, **characterized in that** it further comprises acquisition means (50) for acquiring operating data of the ion source and for transmitting the data to the evaluation means (30) for further processing.

6. Ion engine **characterized in that it** comprises a device (10) according to one of the preceding claims.

7. Use of a device according to any one of claims 1 to 5 for material processing of a surface of an object (100) to be processed.

8. Use of a device according to any one of claims 1 to 5 for coating a surface of an object (100) to be machined.

## Revendications

1. Dispositif (10) pour la production de faisceaux d'ions avec des profils de faisceaux d'ions définis, comprenant :
au moins une source d'ions avec un récipient à plasma (20) et avec une optique ionique (25), l'optique ionique (25) comprenant au moins deux grilles d'extraction (251, 252) séparées électriquement l'une de l'autre pour la production d'un faisceau d'ions, le dispositif (10) présentant une commande de grille (28) pour le déplacement des au moins deux grilles d'extraction (251, 252), de sorte que les positions des grilles d'extraction (251, 252) l'une par rapport à l'autre, ce qui permet de modifier le profil du faisceau d'ions, **caractérisé en ce que** chaque grille d'extraction (251, 252) comporte respectivement plusieurs sous-grilles et la commande de grille (28) est conçue de telle sorte qu'elle peut également déplacer les sous-grilles des au moins deux grilles d'extraction (251, 252), ce qui permet de modifier les positions des sous-grilles l'une par rapport à l'autre, ce qui permet également de modifier le profil du faisceau d'ions.

2. Dispositif (10) selon la revendication 1, **caractérisé en ce qu'**il comprend en outre un moyen de commande (40) pour modifier le profil du faisceau d'ions.

3. Dispositif (10) selon la revendication 1 ou 2, **caractérisé en ce qu'**il comprend en outre un moyen d'évaluation (30) pour la réception et le stockage de données sur les profils de faisceau possibles ainsi que pour la transmission de ces données ou de données dérivées de celles-ci à la commande de grille (28) et au moyen de commande (40) ou à des récepteurs externes.

4. Dispositif (10) selon la revendication 3, **caractérisé en ce qu'**il comprend en outre un moyen d'entrée (60) pour entrer les données relatives aux profils de faisceaux d'ions possibles et pour transmettre ces données au moyen d'évaluation (30).

5. Dispositif (10) selon la revendication 3 ou 4, **caractérisé en ce qu'**il comprend en outre un moyen d'acquisition (50) pour l'acquisition de données de fonctionnement de la source d'ions et pour la transmission des données au moyen d'évaluation (30) pour un traitement ultérieur.

6. Propulseur ionique **caractérisé en ce qu'**il comporte un dispositif (10) selon l'une des revendications précédentes.

7. Utilisation d'un dispositif selon l'une des revendications 1 à 5 pour le traitement de matière d'une surface d'un objet (100) à traiter.

8. Utilisation d'un dispositif selon l'une des revendications 1 à 5 pour le revêtement d'une surface d'un objet (100) à traiter.
